(19) **Europäisches Patentamt**

**European Patent Office**

**Office européen des brevets**

(11) **EP 0 801 451 B1**

(12) **EUROPÄISCHE PATENTSCHRIFT**

(45) Veröffentlichungstag und Bekanntmachung des Hinweises auf die Patenterteilung:
**05.03.2003 Patentblatt 2003/10**

(51) Int Cl.⁷: $H01S\ 5/14$, $H01S\ 5/022$

(21) Anmeldenummer: **97105831.8**

(22) Anmeldetag: **09.04.1997**

(54) **Abstimmvorrichtung**

Tuning arrangement

Arrangement accordable

(84) Benannte Vertragsstaaten:
**DE FR GB IT**

(30) Priorität: **10.04.1996 DE 9606494 U**
**10.02.1997 US 796459**

(43) Veröffentlichungstag der Anmeldung:
**15.10.1997 Patentblatt 1997/42**

(73) Patentinhaber: **Sacher, Joachim**
**35041 Marburg/Lahn (DE)**

(72) Erfinder: **Sacher, Joachim**
**35041 Marburg/Lahn (DE)**

(74) Vertreter: **Olbricht, Karl Heinrich, Dipl.-Phys.**
**Patentanwälte Olbricht & Buchhold,**
**Postfach 11 43**
**35095 Weimar/Lahn (DE)**

(56) Entgegenhaltungen:
**EP-A- 0 702 438          WO-A-94/08371**
**US-A- 5 347 527**

- **HARVEY K C ET AL: "EXTERNAL-CAVITY DIODE LASER USING A GRAZING-INCIDENCE DIFFRACTION GRATING" OPTICS LETTERS, Bd. 16, Nr. 12, 15. Juni 1991, Seiten 910-912, XP000216266**

**Beschreibung**

Die vorliegende Erfindung betrifft eine Abstimmvorrichtung für Halbleiterdiodenlaser mit externem Resonator gemäß dem Oberbegriff des Anspruchs 1.

Durch eine in Flußrichtung betriebene Halbleiterlaserdiode kann man mittels stimulierter Emission kohärentes Licht erzeugen und gerichtet abstrahlen. Die Wellenlänge des emittierten Laserlichts ist durch die jeweilige Stöchiometrie und die mikroskopische Struktur des Halbleiterlasermaterials bestimmt. Typische Emissionswellenlängen von Halbleiterlaserdioden liegen zwischen 630nm und 1550nm.

Für einige Anwendungen von Halbleiterlasern ist es notwendig optische Elemente in den Laserresonator einzubringen, wozu ein externer Resonator dient. Das von einer Laserfacette emittierte Licht wird kollimiert und mit einem separaten (externen) Resonatorendspiegel in den Halbleiterlaser zurückgekoppelt. Die dem externen Resonator zugewandte Laserfacette ist im allgemeinen antireflexionsbeschichtet, um eine bessere Ankopplung des externen Resonators an den Halbleiterlaser zu gewährleisten.

Mit einem externen Resonator, der ein wellenlängenselektives Element enthält, z.B. ein optisches Beugungsgitter, läßt sich die Emissionwellenlänge über den Verstärkungsbereich des Lasers abstimmen. Typische Bandbreiten liegen zwischen 12nm und 120nm, je nachdem ob Halbleiterlaserdioden einer Emissionswellenlänge von 630nm oder solche einer Emissionswellenlänge von 1550nm eingesetzt werden.

Zwei typische Anordnungen für Laserresonatoren, die wellenlängenselektive Elemente enthalten, sind die Littrow- und die Littman-Anordnung. Als Littrow-Anordnung bezeichnet man einen Resonator, der ein optisches Beugungsgitter als Resonatorendspiegel enthält, wobei die Richtungen des einfallenden und des an den Gitterfurchen zurückgestreuten, positiv interferierenden Lichts zusammenfallen. Als Littman-Anordnung bezeichnet man einen gefalteten Resonator, der ein Beugungsgitter zwischen den Resonatorendspiegeln enthält. In dieser Anordnung wird das Gitter so innerhalb des Resonators positioniert, daß die erste Beugungsordnung des Gitters auf den Resonatorendspiegel trifft. Die nullte Beugungsordnung des Gitters kann dann als Nutzstrahl des Lasers eingesetzt werden. Damit hat das Gitter eine Doppelfunktion als wellenlängenselektives Element und als Auskoppelelement.

Der Vorteil der Littman-Anordnung besteht darin, daß die ausgeleuchtete Gitterfläche um einen Faktor 4 bis 7 größer ist als bei der Littrow-Anordnung. Hierdurch ist die spektrale Selektivität des Gitters um den gleichen Faktor erhöht, so daß mit der Littman-Anordnung bei größeren Resonatorlängen einmodige Laseremission gewährleistet ist und mithin sehr geringe Linienbreiten erreicht werden. Ein weiterer Vorteil ist, daß handelsübliche Halbleiterlaser häufig nur in Gehäusebauformen geliefert werden, die keinen Zugang zur rückwärtigen Laserfacette ermöglichen, die in der Littrow-Anordnung als Auskoppelspiegel benötigt wird.

Wird beim Abstimmen der Emissionswellenlänge des Lasersystems die Resonatorlänge konstant gehalten, so ändert sich die Anzahl $m$ der Knoten der stehenden Lichtwelle im Laserresonator, was als Modensprung bezeichnet wird. Hieraus ergibt sich, daß die Wellenlänge nicht kontinuierlich abstimmbar ist, sondern in diskreten Schritten springt. Außer der Schwierigkeit eine gewünschte Wellenlänge einzustellen hat dies zur Folge, daß erhebliche Fluktuationen in der Ausgangsleistung des Lasers auftreten können. Modensprünge lassen sich vermeiden, indem man beim Wellenlängenabstimmen die optische Resonatorlänge $L_{opt}$ so variiert, daß die hierdurch gegebene Wellenlänge $\lambda_R$ der, durch das Gitter bestimmten Wellenlänge $\lambda_G$, nachgeführt wird. Formal muß die Bedingung

$$\left| \frac{2 \cdot L_{opt}}{\lambda_G} - m \right| < \frac{1}{2} \tag{1}$$

erfüllt bleiben.

Für modensprungfreies Wellenlängenabstimmen eines Lasers, der keine dispersiven Medien enthält, hat man eine einfache Drehung eines Resonatorspiegels vorgeschlagen, wobei der Drehpunkt im gemeinsamen Schnittpunkt der Spiegelebenen der Resonatorendspiegel mit der Ebene des Beugungsgitters liegt. Nun zeigen Halbleiterlaser aufgrund ihres Lichtverstärkungsmechanismus eine erhebliche chromatische Dispersion. Infolgedessen ist die geometrische Länge $L_{geo}$ verschieden von der optischen Länge $L_{opt}$. Der formale Zusammenhang lautet:

$$L_{opt} = n(\lambda) \cdot L_{geo} \tag{2}$$

Hierbei ist $n(\lambda)$ der Brechungsindex des Lasermaterials, dessen Wert abhängig von der Emissionswellenlänge des Halbleiterlasers ist. Zur einfacheren Handhabbarkeit entwickelt man Gl. (2) in eine Potenzreihe:

$$L_{opt} \;=\; \left( \sum_{i=0}^{\infty} n_i \cdot \Delta\lambda^i \right) \cdot L_{geo} \qquad\qquad (3)$$

$$n_i \;=\; \frac{d^i n(\lambda_0)}{d\lambda^i}$$

$\Delta\lambda = \lambda - \lambda_0$
$\lambda_0 =$ Entwicklungspunkt

Modensprungsprungfreies Wellenlängenabstimmen von Halbleiterlasern mit externem Resonator über große Wellenlängenbereiche ist nur bei Berücksichtigung der chromatischen Dispersion möglich. Ein Maß für die Ausgleichs-Güte ist die Zahl $i$, bis zu der die Entwicklungskoeffizienten $n_i$ berücksichtigt werden können. Man bezeichnet als "Kompensation der Dispersion $j$-ter Ordnung", wenn die Terme $n_i$ bis einschließlich dem Term $n_j$ exakt berücksichtigt sind. Modensprungfreies Wellenlängenabstimmen eines Halbleiterlasers mit externem Resonator über Bereiche größer als 60nm - 80nm ist im allgemeinen nur möglich, wenn die Dispersion 2-ter Ordnung exakt und die Dispersion 3-ter Ordnung zumindest näherungsweise berücksichtigt wird.

Ein Beispiel für die Kompensation der chromatischen Dispersion aller Komponenten eines Halbleiterlasersystems - bestehend aus Halbleiterlaser, Kollimationsoptik, mit Luft gefüllter externer Resonator - ist in der Veröffentlichung von Favre, Le Guen, "82nm of continuous tunability for an external-cavity semiconductor laser", Electronics Letters, 27 (2), S.183-184, 17. Jan. 1991 gegeben. Favre stellt einen Halbleiterlaseraulbau in Littrow-Anordnung vor, bei dem mittels einer Einstellschraube die globale chromatische Dispersion des Halbleiterlasers, der Abbildungsoptiken und der Luft im externen Resonator kompensierbar ist, allerdings nur die Dispersion erster Ordnung. Ferner ist modensprungfreies Wellenlängenabstimmen nicht über den gesamten Verstärkungsbereich des Lasers möglich; vielmehr treten Modensprünge auf, was durch ungenügende Kompensation der Beiträge zweiter und höherer Ordnung der chromatischen Dispersion des Lasersystems bedingt ist.

Ein zweites, zeitlich späteres Beispiel für die Kompensation der chromatischen Dispersion aller Komponenten eines Halbleiterlasersystems bestehend aus Halbleiterlaser, Kollimationsoptik, mit Luft gefüllter externer Resonator ist in der WO 94/08371 beschrieben. Bei einem Halbleiterlaseraufbau in Littman-Anordnung wird hiernach der Drehpunkt des Spiegelarms so gewählt, daß die chromatische Dispersion 1-ter Ordnung exakt ausgleichbar ist, während für die Dispersion 2-ter Ordnung eine nicht korrigierbare Voreinstellung gewählt wird. Dies hat zur Folge, daß modensprungfreies Wellenlängenabstimmen ebenfalls nicht über den gesamten Abstimmbereich des Lasersystems gelingt.

Die Erfindung dient dem allgemeinen Ziel, Mittel zur Erzeugung von kohärentem Licht mit kontinuierlich und schnell abstimmbarer Wellenlänge geringer spektraler Linienbreite zu schaffen. Insbesondere soll eine einfache Abstimmvorrichtung für einen Halbleiterlaser mit externem Resonator realisert werden, die modensprungfreies Wellenlängenabstimmen über den gesamten Verstärkungsbereich von Halbleiterlasern in Littman-Anordnung ermöglicht.

Wichtige Merkmale der Erfindung sind im kennzeichnenden Teil des Anspruchs 1 gegeben. Ausgestaltungen sind Gegenstand der Ansprüche 2 bis 13.

Bei einer Abstimmvorrichtung für einen mit einer Antireflexionsbeschichtung versehenen Halbleiterdiodenlaser mit externem Resonator in Littman-Anordnung, bestehend aus wenigstens einer optischen Transmissionskomponente, z.B. einem Kollimator, ferner aus einem optischen Beugungsgitter, aus einem um eine Achse drehbaren Abstimmarm, auf dem ein Resonatorendspiegel befestigt ist, sowie aus Stelleinrichtungen für die Position des Abstimmarms und für den Abstand zwischen Spiegelebene und Drehachse zur Kompensation der chromatischen Dispersion erster Ordnung aller im Laser enthaltenen Komponenten (z.B. Halbleiterdiodenlaser, Kollimatoroptik sowie Luft im Resonator), indem die Änderungen der geometrischen Resoantorlänge und der Winkelbeziehung zwischen Gitter und Spiegel mechanisch verknüpft sind, sieht die Erfindung gemäß dem kennzeichnenden Teil von Anspruch 1 vor, daß zur gezielten Einstellung und Kompensation der chromatischen Dispersion höherer Ordnungen das Gitter winkelveränderlich angeordnet und in Bezug auf die Drehachse des Abstimmarms abstandsveränderlich ist. Wird nun der Abstimmarm gedreht, so verursacht dies gleichzeitig eine Translation und eine Rotation des Resonatorendspiegels. Durch dessen Verschiebung ändert sich die geometrische Resonatorlänge $L_{geo}$, mithin gemäß den Gleichungen (2) und (3) auch die optische Resonatorlänge $L_{opt}$ und also die durch den Resonator bestimmte Wellenlänge $\lambda_R$. Die Rotation des Resonatorendspiegel bewirkt eine Änderung der durch das Gitter bestimmten Wellenlänge $\lambda_G$. Dies erfolgt erfindungsgemäß so, daß Gleichung (1) jederzeit erfüllt bleibt, indem die Änderung der durch das Gitter bestimmten Wellenlänge $\lambda_G$ synchronisiert ist.

Wichtig ist die Maßnahme des Kennzeichnenden Teils von Anspruch 1, wonach zum Ausgleich der chromatischen Dispersion je einer Ordnung (1.; 2.; 3.) jeweils ein Justiermittel vorhanden ist. Mithin kann in einer einfach zu handhabenden Feinabstimmung jede einzelne Einstellung optimiert werden.

Die erfindungsgemäße Abstimmvorrichtung bedeutet gegenüber der Veröffentlichung WO 94/08371 einen beachtlichen Fortschritt. Dort ist nur eine einzige Vorrichtung zur Kompensation vorgesehen, womit also nur die chromatische Dispersion 1. Ordnung kompensiert werden kann. Eine nicht korrigierbare Voreinstellung wird für die chromatische Dispersion 2. Ordnung gewählt. Da aber der Brechungsindex von Halbleiterlasern eine komplizierte Funktion der Wellenlänge ist, muß man für eine genügend genaue Kompensation im Verstärkungsbereich von Halbleiterlasern mindestens den Beitrag 3. Ordnung der chromatischen Dispersion ($n_3$) mitberücksichtigen. Wird hierauf verzichtet, so ergibt sich eine Obergrenze des modensprungfreien Abstimmbereichs bei ca. 60nm bis 80nm für 1,55 µm Laserdioden. Erfindungsgemäß ist hingegen modensprungfreies Wellenlängenabstimmen über den gesamten Verstärkungsbereich von Halbleiterlaserdioden möglich, indem die Dispersion 2. Ordnung exakt und die Dispersion 3. Ordnung nahezu exakt kompensierbar ist.

Laut Anspruch 2 ist zur Einstellung des Abstands zwischen Drehachse und Spiegelebene ein Justiermittel für die Translation des Resonatorendspiegels in Richtung der Spiegelnormalen vorhanden. Dies kann insbesondere nach Anspruch 3 eine großkalibrige Feingewindeschraube sein, auf welcher der Spiegel so befestigt ist, daß seine Normale zur Schraubachse parallel verläuft. Konstruktiv günstig ist es dabei, wenn der Resonatorendspiegel im Einklang mit Anspruch 4 ein rechtwinkliges Prisma solcher Bemessung ist, daß der vom Gitter kommende Lichtstrahl über die Hypothenusenfläche in das Prisma eindringt, an den beiden Kathetenflächen nacheinander Totalreflexion erfährt und anschließend über die Hypothenusenfläche aus dem Prisma austritt, wobei die Schnittgerade der Prismakathetenflächen senkrecht zu den Furchen des Gitters steht. Dank dieser Ausrichtung des Prismas wird die optimale Güte des Laserresonators ohne Beeinträchtigung der Wellenlängenselektivität des Gitters gewährleistet. Damit ist Resonator weitgehend unempfindlich gegen Justagefehler, wodurch der Einsatz des Lasers unter rauen Alltagsbedingungen möglich ist.

Eine Alternative zu Anspruch 4 wird in Anspruch 5 formuliert. Wird zwischen Gitter und Resonatorendspiegel eine Zylinderlinse so eingefügt, daß die Längsachse der Zylinderlinse in etwa senkrecht zu den Gitterfurchen steht, und daß die Spiegelebene des Resonatorendspiegels in der Brennebene der Zylinderlinse steht, so erhält man ebenfalls eine weitgehende Unempfindlichkeit des Resonators gegen Justagefehler.

Sehr vorteilhaft ist das Merkmal von Anspruch 6, wonach das Gitter auf einem Gitterhalter mit zwei Verstellfreiheitsgraden befestigt ist. Der Gitterhalter kann insbesondere nach Anspruch 7 mit Hilfe von Justiermitteln in zwei Richtungen drehbar sein, wobei die Drehachsen zueinander senkrecht stehen. Nach Anspruch 8 verläuft eine erste Drehrichtung entlang einer Achse des Gitterhalters, was die Justage der Resonatorgüte gestattet. Eine zweite Drehrichtung verläuft nach Anspruch 9 entlang einer Achse des Gitterhalters, wodurch der Einfallswinkel des vom Halbleiterdiodenlaser emittierten Lichts auf das Gitter eingestellt werden kann. Indem die erste Drehachse parallel zu den Gitterfurchen liegt und die zweite Drehachse senkrecht zu letzteren steht, spannen die beiden Drehachsen eine Ebene auf, die parallel zur Gitterebene verläuft. Diese Anordnung trägt außerordentlich zur bequemen und zuverlässigen Einstellbarkeit bei.

Für die Veränderung des Abstandes zwischen Gitterebene und Drehachse des Abstimmarms sieht Anspruch 11 einen Verschiebetisch vor auf dem der Gitterhalter zusammen mit dem Gitter befestigt ist. Diese Anordnung ist sehr stabil. Gemäß Anspruch 11 ist als Justiermittel für die Translation des Gitters und des Gitterhalters vorzugsweise in Richtung der Gitternormalen am Verschiebetisch eine Feingewindeschraube vorhanden, so daß die Abstandsjustierung sehr genau erfolgen kann.

Bei einer Vorrichtung der eingangs genannten Art sieht die Erfindung gemäß dem abhängigen Anspruch 12 eine Kombination vor, die eine zweidimensionale Anordnung zur gezielten Einstellung und Kompensation der chromatischen Dispersion höherer Ordnungen derart aufweist, daß das Gitter auf einem Gitterhalter winkelveränderlich montiert ist und daß dieser auf einem Verschiebetisch sitzt, mit dem das Gitter in Bezug auf den Drehpunkt des Abstimmarms abstandveränderlich ist. In dieser Weise ist eine Arbeitsebene definiert, in der die erforderlichen Kompensationseinstellungen rasch und effektiv vorgenommen werden können.

Ebenfalls von grundsätzlicher Bedeutung ist die Abstimmvorrichtung nach dem weiteren abhängigen Anspruch 13 die sich dadurch auszeichnet, daß zur gezielten Einstellung und Kompensation der chromatischen Dispersion höherer Ordnung das Gitter auf einem Gitterhalter so montiert ist, daß der Einfallswinkel des von Halbleiterdiodenlaser emittierten Lichts auf das Gitter einstellbar veränderlich ist, während der Gitterhalter auf einem Verschiebetisch derart angebracht ist, daß der Abstand zwischen der Gitterebene und dem Drehpunkt des Abstimmarms einstellbar veränderlich ist. Die drei maßgeblichen Einstell-Möglichkeiten sind in dieser Kombination auf einfache und übersichtliche Weise vereinigt.

Weitere Merkmale, Einzelheiten und Vorteile der Erfindung ergeben sich aus dem Wortlaut der Ansprüche sowie aus der folgenden Beschreibung von Ausführungsbeispielen anhand der Zeichnungen. Darin zeigen

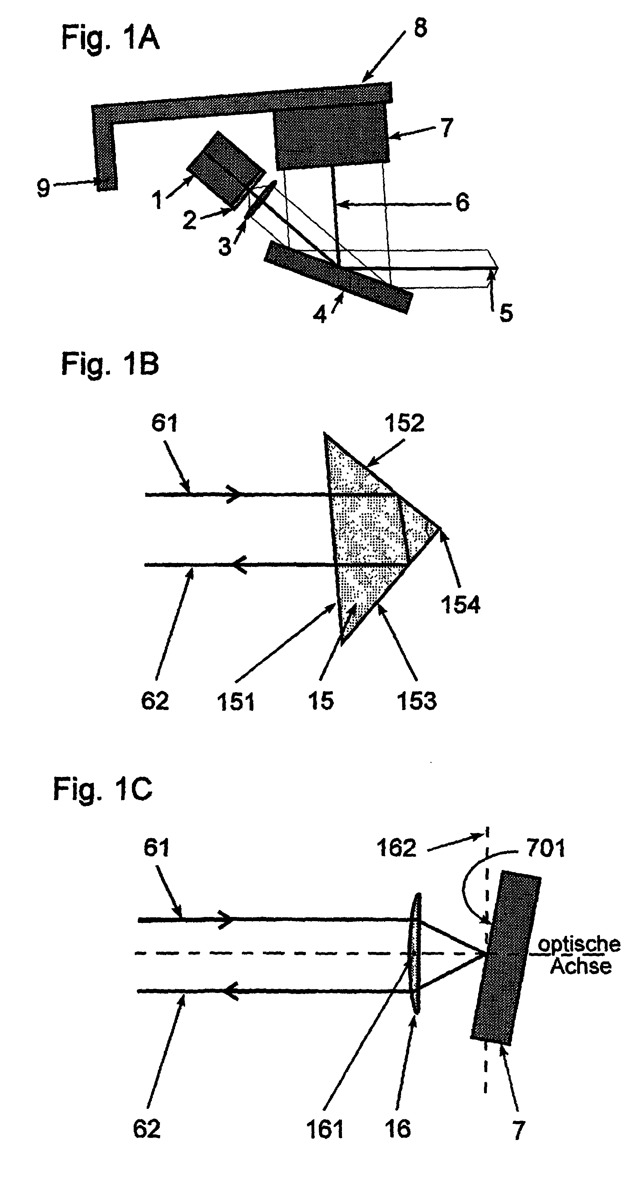

**Fig. 1A:** eine schematische Darstellung der Grundanordnung einer Abstimmvorrichtung,

| **Fig. 1B:** | einen Prisma-Strahlengang, |
| **Fig. 1C:** | Strahlengang mit Zylinderlinse und Spiegel, |
| **Fig. 2:** | eine schematische Darstellung einer bevorzugten Bauform einer Abstimmvorrichtung, |
| **Fig. 3A:** | eine schematisierte Seiten-/Schnittansicht eines Gitterhalters mit Einstellmitteln, |
| **Fig. 3B:** | eine schematisierte Seiten-/Schnittansicht einer Winkeljustiereinrichtung, |
| **Fig. 4A, 4B, 4C:** | je eine Seitenanstict und Draufsicht von Drehachsausbildungen, |
| **Fig. 5:** | Eine schematische Darstellung der optischen Verhältnisse der Gesamtanordnung und |
| **Fig. 6:** | ein Wellenlängen-Abstimmdiagramm. |

In Fig. 1A ist eine Halbleiterlaserdiode mit externem Resonator in Littman-Anordnung dargestellt. Ein Halbleiterlaser 1 hat eine mit einer Antireflexionsbeschichtung 2 versehene Spiegelfacette, die dem externen Resonator zugewandt ist. Eine Linse 3 kollimiert das von der Spiegelfacette emittierte Laserlicht, daß unter einem Einfallswinkel $\theta_1$ auf die Oberfläche eines Beugungsgitters 4 trifft. Licht der nullten Beugungsordnung 5 wird als Nutzstrahl des Lasers ausgekoppelt. Licht der ersten Beugungsordnung 6 trifft auf den externen Resonatorendspiegel 7, wird dort reflektiert und, nachdem es vom Gitter 4 ein zweites Mal gebeugt wurde, in den Laser 1 zurückgekoppelt. Der Spiegel 7 ist auf einem Abstimmarm 8 befestigt und dieser um eine zur Spiegelebene 701 parallele Drehachse 9 drehbar gelagert. Wird der Abstimmarm 8 um die Drehachse 9 gedreht, so ändert sich die durch das Gitter 4 bestimmte Wellenlänge $\lambda_G$ und gleichzeitig die durch die Resonatorlänge bestimmte Wellenlänge $\lambda_R$.

Fig. 1B zeigt einen Hauptschnitt eines Prismas 15. Die Schnittebene wird von zwei sich kreuzenden Normalen der Kathetenflächen 152 und 153 aufgespannt. Ein vom Gitter 4 kommender, in dieser Ebene verlaufender Strahl dringt über die Hypothenusenfläche 151 in das Prisma 15 ein, wird nacheinander an den Kathetenflächen 152, 152 totalreflektiert und verläßt das Prisma 15 über die Hypothenusenfläche 151 wieder. Einfallender Strahl 61 und ausfallender Strahl 62 sind antiparallel zueinander. Wenn der ausfallende Strahl 62 nach der Beugung am Gitter 4 auf die Kollimatorlinse 3 trifft, wird er wieder in den Halbleiterlaser 1 zurückgekoppelt, und zwar weitgehend unabhängig vom Winkel zur Hypothenusenfläche 151.

Fig. 1C zeigt einen Schnitt durch Zylinderlinse 16 und Resonatorendspiegel 7, derart daß die Schnittebene senkrecht zur Längsachse 162 der Zylinderlinse 16 steht. Ein vom Gitter kommender, in dieser Ebene verlaufender Strahl, der parallel zur optischen Achse der Zylinderlinse ist, wird in Richtung der optischen Achse der Zylinderlinse 16 gebrochen, an der Spiegelebene 701 reflektiert und danach ein zweites Mal an der Zylinderlinse 16 gebrochen. Wird der Abstand zwischen Zylinderlinse 16 und Spiegelebene 701 gleich der spiegelseitigen Brennweite der Zylinderlinse 16 gewählt, so einfallender Strahl 61 und ausfallender Strahl 62 antiparallel zueinander. Wenn der ausfallende Strahl 62 nach der Beugung am Gitter 4 auf die Kollimatorlinse 3 trifft, wird er wieder in den Halbleiterlaser 1 zurückgekoppelt, und zwar weitgehend unabhängig vom Winkel der Spiegelebene 701 zu einfallendem 61 und ausfallendem Strahl 62.

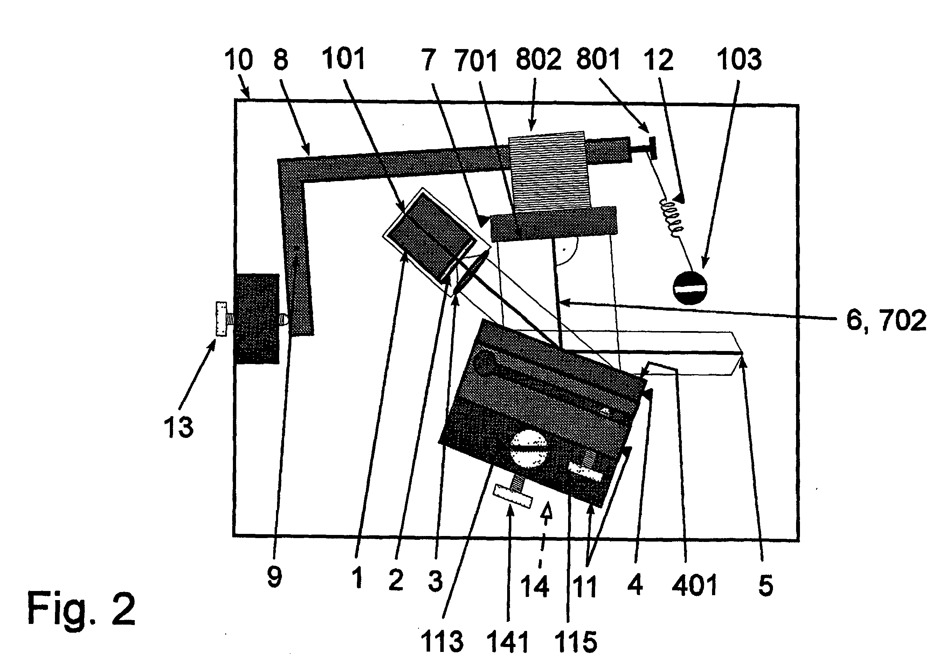

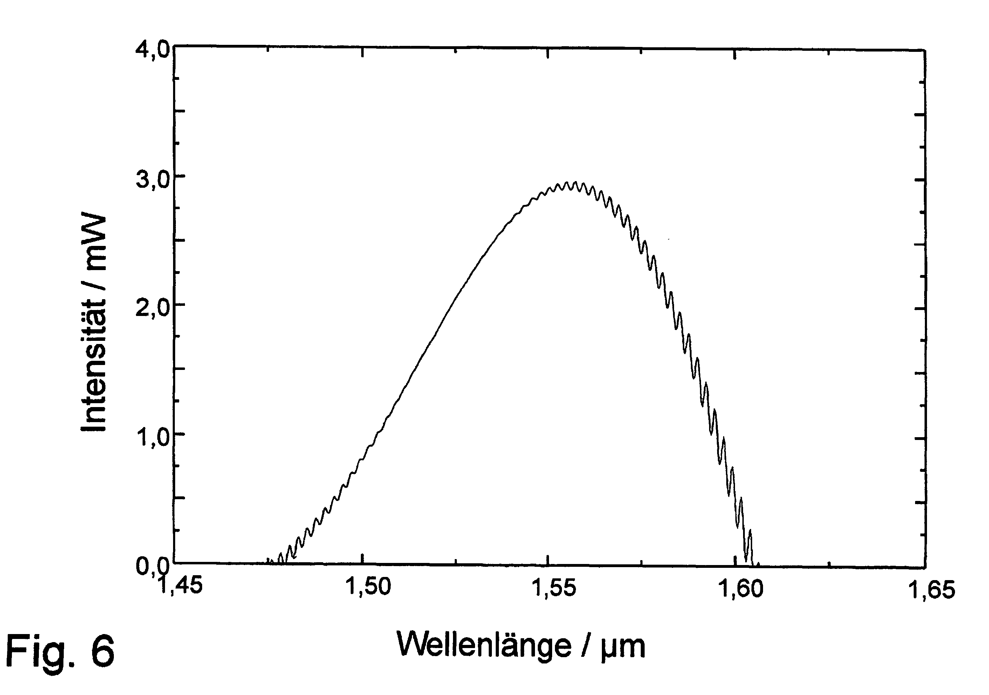

Fig. 2 zeigt eine Draufsicht auf eine bevorzugte Ausführungsform der erfindungsgemäßen Abstimmvorrichtung. Der einseitig antireflexionsbeschichtete Halbleiterdiodenlaser 1 ist zusammen mit der Kollimatorlinse 3 auf einer Grundplatte 10 fest montiert, auf der auch das Gitter 4 zusammen mit dem Gitterhalter 11 befestigt ist. Der Abstimmarm 8, der den externen Resonatorendspiegel 7 trägt, ist so mit der Grundplatte 10 so verbunden, daß er sich nur entlang der Drehachse 9 drehen kann. Eine Rückstellfeder 12 drückt den Abstimmarm 8 gegen eine Verstelleinheit 13, die vorzugsweise aus einer Mikrometerschraube sowie einem Piezotranslator besteht und die genaue Einstellung des Abstimmarms 8 kontrolliert. Wird die Mikrometerschraube gedreht oder die am Piezotranslator anliegende elektrische Spannung verändert, so bewirkt das gleichzeitig eine Rotation und eine Translation des Resonatorendspiegels 7. Die Rotation verändert den Ausfallswinkels $\theta_2$ (Fig. 5) des Lichts der ersten Beugungsordnung, d.h. des Abstimmstahls 6 und mithin die vom Gitter 4 bestimmte Wellenlänge $\lambda_G$. Die Translation verändert die Resonatorlänge $L_{opt}$ und damit die hiervon bestimmte Wellenlänge $\lambda_R$.

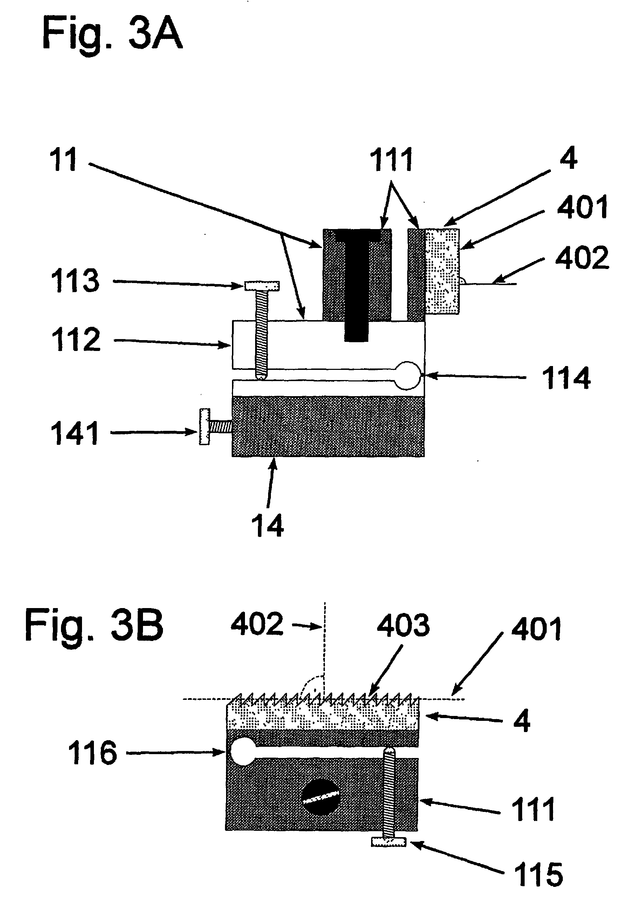

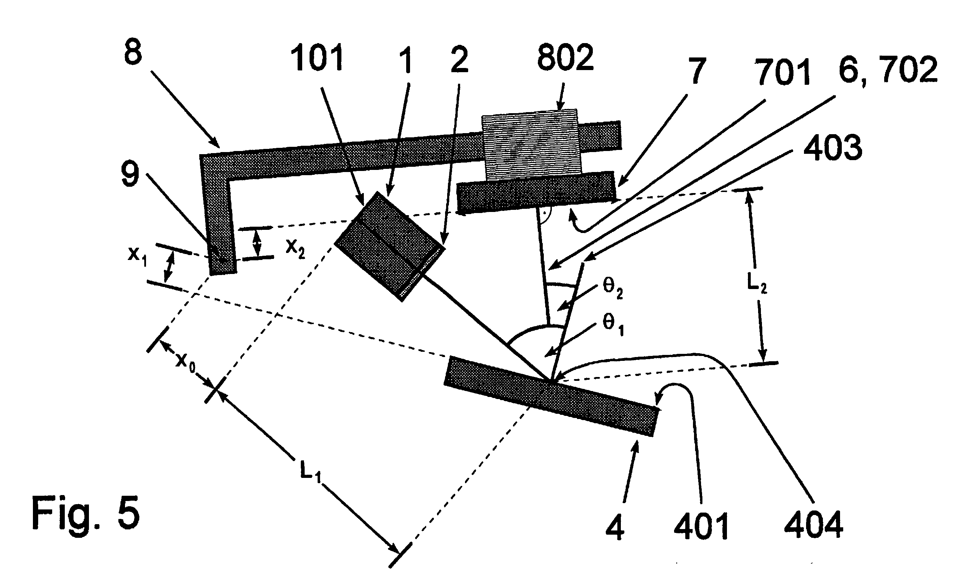

Fig. 2 zeigt ferner einen Verschiebetisch 14, dessen Komponenten aus Fig. 3A und 3B noch deutlicher hervorgehen. Man erkennt, daß der Gitterhalter 11 aus einem oberen Teil 111 und einem unteren Teil 112 besteht, die miteinander verschraubt und auf einem Verschiebetische 14 befestigt sind. Der untere Teil 112 des Gitterhalters 11 ist ein Biegeelement, das von einer Feingewindeschraube 113 auseinandergedrückt wird. Durch deren Drehen wird das Gitter 4 um eine Achse 114 gedreht die zumindest näherungsweise parallel zu Gitterebene 401 liegt und senkrecht zu den Gitterfurchen 403 steht. Diese Einstellmöglichkeit gestattet die Justage der Resonatorgüte.

Der Verschiebetisch 14 hat ferner eine Feingewindeschraube 141, deren Drehen eine Translation des Gitterhalters 11 und des Gitters 4 in eine Richtung ermöglicht, die zumindest näherungsweise der Richtung der Gitternormalen 402 entspricht. Dieser Einstellfreiheitsgrad dient zur Festlegung des modensprungfreien Wellenlängendurchstimmbereichs.

Fig. 3B zeigt einen Schnitt durch den oberen Teil 111 des Gitterhalters 11 (vgl. Fig. 3A). Der obere Teil 111 ist ebenfalls ein Biegeelement, das von einer Feingewindeschraube 115 auseinandergedrückt wird, deren Drehen eine Rotation des Gitters 4 um eine Achse 116 parallel zu den Gitterfurchen 403 bewirkt. Auch dies trägt zur Einstellung des maximalen modensprungfreien Wellenlängendurchstimmbereichs bei. Sind die Einstellungen des Gitterhalters 11 und des Verschiebetischs 14 einmal vorgenommen, so können sie während des übrigen Durchstimmverfahrens unverändert bleiben.

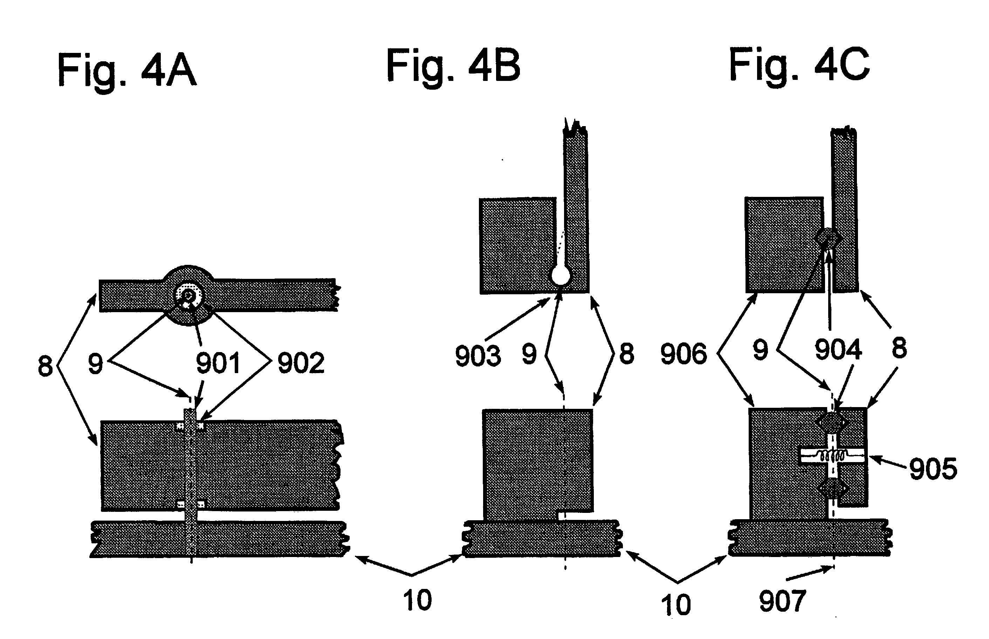

Aus Fig. 2 sowie Fig. 4A, 4B, 4C gehen mögliche Realisierungen des Abstimmarms 8 hervor. Er trägt eine Schraube 801, an der die Rückstellfeder 12 befestigbar ist. Der Resonatorendspiegel 7 sitzt auf einer großkalibrigen Feingewindeschraube 802, die in den Abstimmarm eingeschraubt ist und durch ihre Drehung eine Translation des Spiegels 7 in Richtung der Spiegelnormalen 702 gestattet. Eine einmal vorgenommene Einstellung des Abstimmarms (8) kann während des übrigen Durchstimmverfahrens unverändert bleiben.

Eine konstruktive Möglichkeit ist in Fig. 4A veranschaulicht. Hier ist die Drehachse 9 ein Metallstab 901, der mit dem Abstimmarm 8 drehbar über Lager 902 und mit der Grundplatte 10 fest verbunden ist. Bei der Variante gemäß Fig. 4B sitzt der Abstimmarm 8 ebenfalls fest auf der Grundplatte 10, doch hat er eine Einschnürung 903, die als Drehachse 9 wirkt. Fig. 4C veranschaulicht einen Abstimmarm 8, der über zwei Kugeln 904 und eine Feder 905 mit einem Stab 906 verbunden ist, welcher wiederum auf der Grundplatte 10 befestigt ist. Die Drehachse 9 liegt dabei in der Verbindungslinie 907 der Mittelpunkte der Kugeln 904. Man erkennt, daß alle diese Varianten eine hochpräzise, praktisch spielfreie Drehbewegung des Abstimmarms 8 erlauben, wie sie zum modensprungfreien Wellenlängenabstimmen des Lasers 1 benötigt wird. Wie aus Fig. 6 hervorgeht, wo in einem Diagramm die Laserstrahl-Intensität in Abhängigkeit von der Wellenlänge dargestellt ist, besteht im Meßbeispiel ein modensprungfreier Verlauf über einen Wellenlängenbereich von 130nm, was im wesentlichen einer Bereichsverdopplung gegenüber der herkömmlichen Technik gleichkommt.

Im folgenden wird die Funktion der erfindungsgemäßen Abstimmvorrichtung anhand von Fig. 5 weiter erläutert. Man sieht, daß der Abstand $x_2$ zwischen der Drehachse 9 und der Spiegelebene 701 einstellbar veränderlich ist. Letztere enthält Geraden, die parallel zur Drehachse 9 verlaufen, wodurch die geometrische Begriffs-Definition für den Abstand zwischen Punkt und Gerade in üblicher Weise anwendbar ist. Indem der Resonatorendspiegel 7 mit Hilfe der Schraube 802 in Richtung seiner Normalen 702 translatiert wird verändert sich die Resonatorlänge $L_{geo}$, ohne daß hierdurch die vom Gitter 4 bestimmte Wellenlänge $\lambda_G$ verändert würde. Hierdurch ist also eine ausschließliche Änderung der Knotenzahl $m$ der stehenden Welle im Laserresonator möglich. Rotation und Translation des Resonatorendspiegels 7 sind so synchronisiert, daß sich die vom Gitter 4 bestimmte Wellenlänge $\lambda_G$ und die von der Resonatorlänge $L_{opt}$ bestimmte Wellenlänge $\lambda_R$ um weniger als ein Viertel der Wellenlänge unterscheiden (siehe. Gl. (1)). Weil der Brechungsindex von Halbleiterlasern im Gegensatz beispielsweise zu einem Gaslaser oder Farbstofflaser eine erhebliche chromatische Dispersion aufweist, unterscheidet sich die geometrische Länge $L_{geo}$ gemäß Gl. (3) beträchtlich von der optischen Länge $L_{opt}$. Die in der Erfindungsgemäßen Abstimmvorrichtung vorhandenen Justiermittel ermöglichen nun die Kompensation auf überraschend einfache und betriebssichere Weise. Die Einstellschraube 802 dient zur Kompensation der Dispersion 1. Ordnung aller im Laserresonator enthaltenen Komponenten (Halbleiterlaser 1, Antireflektionsbeschichtung 2, Kollimatoroptik 3, Luft). Mittels der Feingewindeschraube 141 wird die Dispersion 2. Ordnung exakt kompensiert. Die Feingewindeschraube 115 gestattet die Kompensation der Dispersion 3. Ordnung sowie eine Vorwahl des Ausgleichs der Dispersion 4. Ordnung.

In Fig. 5 sind die relevanten optisch-geometrischen Größen schematisch dargestellt. $\theta_1$ bezeichnet den Einfallswinkel des vom Laser 1 emittierten Lichts auf das Gitter 4; er kann mittels der Einstellschraube 115 eingestellt werden. Mit $x_1$ wird der Abstand zwischen der Gitterebene 401 und dem Drehpunkt 9 des Abstimmarms 8 bezeichnet. Dieser Abstand $x_1$ wird durch Translation des Gitter 4 in Richtung der Gitternormalen 403 justiert, und zwar durch Drehen der Einstellschraube 141 des Verschiebetischs 14, wodurch eine Translation des Gitterhalters 11 zusammen mit dem Gitter 4 bewirkt wird. Kleine Winkeldifferenzen zwischen Translationsrichtung und Gitternormalen 402 die durch Rotation des Gitters 4 um die Drehachsen 115 bzw. 116 verursacht werden könnten, stören die Einstellung des Abstandes $x_1$ nicht.

$x_2$ bezeichnet den Abstand zwischen der Spiegelebene 701 und dem Drehpunkt 9 des Abstimmarms 8; dies ist mit der Scharube 802 einstellbar. Die geometrische Resonatorlänge $L_{geo}$ setzt sich aus zwei Teillängen $L_1$ und $L_2$ zusammen. Teillänge $L_1$ ist der geometrische Abstand zwischen der Resonatorendfläche 101 und der Mitte 404 der ausgeleuchteten Fläche des Gitters 4. Die Teillänge $L_2$ ist durch den geometrischen Abstand zwischen der Spiegelebene 701 und der Mitte 404 der ausgeleuchteten Fläche des Gitters 4 gegeben. Gemäß den Gleichungen (2) und (3) besteht also der Zusammenhang

$$L_{opt} = n(\lambda) \cdot (L_1 + L_2). \tag{4}$$

Diese Beschreibung der Dispersion des Halbleiterlasermaterials kann leicht auf die Dispersion aller im Resonator enthaltener Medien erweitert werden, z.B. indem man deren Brechungsindexfunktionen entsprechend ihrer Länge gewichtet und aufsummiert. Die globale Dispersion aller im Resonator enthaltenen Medien verursacht einen Unterschied zwischen der Resonatorwellenlänge $\lambda_R$ und der Gitterwellenlänge $\lambda_G$, der in einer Reihenentwicklung wie folgt zu beschreiben ist:

$$\lambda_R - \lambda_G = f_1 \cdot \Delta\lambda + f_2 \cdot \Delta\lambda^2 + f_3 \cdot \Delta\lambda^3 + ... \tag{5}$$

$f_i$ = Entwicklungskoeffizient
$\Delta\lambda = \lambda_G - \lambda_0$
$\lambda_0$ = Entwicklungspunkt

Speziell sind $f_1$, $f_2$, $f_3$ Funktionen der Einstellgrößen $\theta_1$, $x_1$ und $x_2$. Mit deren Hilfe kann der Wert der Entwicklungskoeffizienten gewählt werden, was nachfolgend in der Reihenfolge des Justagevorgangs am Laserresonator angegeben wird.

$x_2$: Der Wert von $x_2$, der mittels der Einstellungschraube 802 des Abstimmarms 8 gewählt wird, dient zur exakten Kompensation des Entwicklungskoeffizienten $f_1$.

$x_1$: Der Wert von $x_1$, der mittels der Einstellungschraube 141 des Verschiebetischs 14 - auf dem der Gitterhalter 11 zusammen dem Gitter 4 befestigt ist - eingestellt wird, führt zur exakten Kompensation des Entwicklungskoeffizienten $f_2$.

$\theta_1$: Der Wert des Einfallswinkels $\theta_1$ am Gitter 4 ist mittels der Einstellschraube 115 in einem genügend großem Intervall einstellbar. Seine Wahl gewährleistet die exakte Kompensation des Entwicklungskoeffizienten $f_3$.

Man erkennt, daß die erfindungsgemäße Abstimmvorrichtung nicht nur verhältnismäßig robust aufgebaut, sondern auch außerordentlich feinfühlig bedienbar ist und es erstmals möglich macht, die Emissionswellenlänge von Halbleiterdiodenlasern über den gesamten Verstärkungsbereich modensprungfrei abzustimmen. Rechnerische Werte für den Durchstimmbereich liegen um ein vielfaches oberhalb des Verstärkungsbereichs von Halbleiterlasern. Daher ergibt sich sogar ein großer Toleranzbereich für die Wahl der vorgenannten Justiermittel (802, 141, 115), mit denen sich der Einstellvorgang schnell und sicher vornehmen läßt. Dabei ist die Resonatorgüte weitgehend unempfindlich gegen äußere Störungen, die Justagefehler verursachen können. Das Wellenlängendurchstimmverhalten beim Drehen des Abstimmarms 8 um die Drehachse 9 bleibt erhalten, ohne daß die spektrale Selektivität des Gitterresonators beeinflußt würde.

Die Erfindung ist nicht auf die dargestellten und beschriebenen Beispiele beschränkt, sondern in vielfältiger Weise abwandelbar. Man erkennt jedoch, daß bei einer bevorzugten Ausführungsform eines Halbleiterdiodenlasers 1 mit einer Antireflexionsbeschichtung 2, Kollimatoroptik 3, Reflexionsbeugungsgitter 4 und Resonatorendspiegel 7 in Littman-Anordnung Ausfallswinkel $\theta_2$ des Gitters und die geometrische Resonatorlänge $L_{geo}$ mechanisch verknüpft sind, um die chromatische Dispersion aller im Resonator enthaltenen Medien (Halbleiterdiodenlaser 1, Antireflexionsbeschichtung 2, Kollimatoroptik 3, Luft) bei Drehung des Spiegels 7 um die Drehachse 9 so genau zu kompensieren, daß jedenfalls der Ausgleich für die Dispersion erster, zweiter und dritter Ordnung mit Hilfe von Justiermittls 802, 141, 115 bewirkt wird und so modensprungfreies Wellenlängendurchstimmen über den gesamten Verstärkungsbereich des Halbleiterdiodenlasers 1 sicher gewährleistet ist.

Sämtliche aus den Ansprüchen, der Beschreibung und der Zeichnung hervorgehenden Merkmale und Vorteile, einschließlich konstruktiver Einzelheiten, räumlicher Anordnungen und Verfahrensschritten, können sowohl für sich als auch in den verschiedensten Kombinationen erfindungswesentlich sein.

**Bezugszahlenliste**

1    Halbleiterlaser

| | |
|---|---|
| 2 | Antireflexionsbeschichtung |
| 3 | Linse/Kollimatoroptik |
| 4 | (Beugungs-) Gitter |
| 5 | Nutzstrahl |
| 6 | Abstimmstrahl |
| 7 | Resonatorendspiegel |
| 8 | Abstimmarm |
| 9 | Drehachse |
| 10 | Grundplatte |
| 11 | Gitterhalter |
| 12 | Rückstellfeder |
| 13 | Verstelleinheit |
| 14 | Verschiebetisch |
| 15 | Prisma |
| 16 | Zylinderlinse |
| 61 | Einfallstrahl |
| 62 | Ausfallstrahl |
| 101 | Resonatorendfläche |
| 111 | oberer Teil |
| 112 | unterer Teil |
| 113 | Feingewindeschraube |
| 114 | Drehachse |
| 115 | Feingewindeschraube |
| 116 | Drehachse |
| 141 | Feingewindeschraube |
| 151 | Hypothenusenfläche |
| 152 | erste Kathetenfläche |
| 153 | zweite Kathetenfläche |
| 154 | Schnittgerade |
| 161 | Längsachse der Zylinderlinse |
| 162 | Brennebene der Zylinderlinse |
| 401 | Gitterebene |
| 402 | Gitternormale |
| 403 | Gitterfurchen |
| 404 | Strahlmittelpunkt |
| 701 | Spiegelebene |
| 702 | Spiegelnormale |
| 801 | Schraube |
| 802 | (Einstell-) Schraube |
| 901 | Metallstab |
| 902 | Lager |
| 903 | Einschnürung |
| 904 | Kugeln |
| 906 | Stab |
| 907 | Verbindungslinie |

**Bezugssybolliste**

| | |
|---|---|
| $\lambda$ | Emissionswellenlänge des Halbleiterlasers mit externem Resonator |
| $\lambda_0$ | Entwicklungspunkt |
| $\lambda_G$ | Durch das Beugungsgitter bestimmte Wellenlänge |
| $\lambda_R$ | Durch den Resonator bestimmte Wellenlänge |
| $L_{geo}$ | Geometrische Länge des Laserresonators |
| $L_{opt}$ | Optische Länge des Laserresonators |
| $L_1$ | Erste Teillänge des Resonators |
| $L_2$ | Zweite Teillänge des Resonators |

$m$      Anzahl der Wellenknoten im Resonator

$n(\lambda)$      Wellenlängenabhängiger Brechungsindex der Laserdiode 1

$n_i$      $i$-ter Enwicklungskoeffizient des Brechungsindex am Entwicklungspunkt $\lambda_0$

$f_i$      $i$-ter Enwicklungskoeffizient der Abweichung zwischen $\lambda_G$ und $\lambda_R$ am Entwicklungspunkt $\lambda_0$

$\theta_1$      Einfallswinkel des Gitters 4

$\theta_2$      Ausfallswinkel der ersten Beugungsordnung des Gitters 4

$x_0$      Abstand zwischen Drehpunkt 9 und Resonatorendspiegel 101

$x_1$      Abstand zwischen Drehpunkt 9 und Gitterebene 401

$x_2$      Abstand zwischen Drehpunkt 9 und Resonatorendfläche 7

**Patentansprüche**

1. Abstimmvorrichtung für einen mit einer Antireflexionsbeschichtung (2) versehenen Halbleiterdiodenlaser (1) mit externem Resonator in Littman-Anordnung, bestehend aus wenigstens einer optischen Transmissionskomponente (3), einem optischen Beugungsgitter (4), ferner aus einem um eine Achse (9) drehbaren Abstimmarms (8), auf dem ein Resonatorendspiegel (7) befestigt ist, sowie aus Stelleinrichtungen (13, 802) für die Position des Abstimmarm (8) und der den Abstand ($x_2$) zwischen Spiegelebene (701) und Drehachse (9) zur Kompensation der chromatischen Dispersion erster Ordnung aller im Laser enthaltenen Komponenten, indem die Änderungen der geometrischen Resonatorlänge $L_{geo}$ und der Winkelbeziehung zwischen Gitter (4) und Spiegel (7) mechanisch verknüpft sind, **dadurch gekennzeichnet, daß** zur gezielten Einstellung und Kompensation der chromatischen Dispersion höherer Ordnungen das Gitter (4) winkelveränderlich angeordnet und in Bezug auf die Drehachse (9) des Abstimmarms (8) abstandsveränderlich ist, wobei zum Ausgleich der chromatischen Dispersion je einer Ordnung jeweils ein Justiermittel (802; 141; 115) vorhanden ist.

2. Vorrichtung nach Anspruch 1, **dadurch gekennzeichnet, daß** zur Einstellung des Abstandes $x_2$ zwischen Drehachse (9) und Spiegelebene (701) der Resonatorendspiegel (7) mit einem Justiermittel (802) in Richtung der Spiegelnormalen (702) translatierbar ist.

3. Vorrichtung nach Anspruch 2, **dadurch gekennzeichnet, daß** das Justiermittel eine großkalibrige Feingewindeschraube (802) ist, auf welcher der Spiegel (7) so befestigt ist, daß durch Drehen der Feingewindeschraube (802) der Spiegel (7) in Richtung der Spiegelnormalen (702) verschieblich ist.

4. Vorrichtung nach Anspruch 1 oder 2, **dadurch gekennzeichnet, daß** der Resonatorendspiegel (7) ein rechtwinkliges Prisma (15) solcher Bemessung ist, daß der vom Gitter (4) kommende, in das Prisma (15) einfallende Lichtstrahl (6) über die Hypothenusenfläche (151) in das Prisma (15) eindringt, an der ersten Kathetenfläche (152) sowie an der zweiten Kathetenfläche (153) Totalreflexion erfährt und danach aus dem Prisma (15) über die Hypothenusenfläche (151) wieder austritt, wobei die Schnittgerade (154) der Kathetenflächen (151, 152) des Prismas (15) senkrecht zu den Furchen (402) des Gitters (4) steht.

5. Vorrichtung nach Anspruch 1 oder 2, **dadurch gekennzeichnet, daß** zwischen Gitter (4) und Resonatorendspiegel (7) eine Zylinderlinse (16) positioniert ist, derart, daß die Richtung der Längsachse (161) der Zylinderlinse (16) in etwa senkrecht zu den Gitterfurchen (402) steht und daß der Abstand zwischen Spiegelebene (701) des Resonatorendspiegels (7) und der Zylinderlinse (16) gleich der spiegelseitigen Brennweite der Zylinderlinse (16) ist.

6. Vorrichtung nach einem der Ansprüche 1 bis 5, **dadurch gekennzeichnet, daß** das Gitter (4) auf einem Gitterhalter (11) mit zwei Verstellfreiheitsgraden befestigt ist.

7. Vorrichtung nach Anspruch 6, **dadurch gekennzeichnet, daß** der Gitterhalter (11) mit Hilfe von Justiermitteln (113, 115) in zwei Richtungen drehbar ist, wobei die Drehachsen zueinander senkrecht stehen.

8. Vorrichtung nach Anspruch 7, **dadurch gekennzeichnet, daß** zur Justage der Resonatorgüte eine erste Drehrichtung entlang einer Achse (114) des Gitterhalters (11) verläuft.

9. Vorrichtung nach einer der Ansprüche 6 bis 8, **dadurch gekennzeichnet, daß** zur Wahl des Einfallswinkels ($\theta_1$) des vom Halbleiterdiodenlaser (1) ermittierten Lichts auf das Gitter (4) eine zweite Drehrichtung entlang einer Achse (116) des Gitterhalters (11) verläuft.

**10.** Vorrichtung nach einem der Ansprüche 6 bis 9, **dadurch gekennzeichnet, daß** der Abstand (x 1) zwischen Gitterebene (401) und der Drehachse (9) des Abstimmarms (8) mittels eines Verschiebetischs (14) veränderbar ist, auf dem der Gitterhalter (11) zusammen mit dem Gitter (4) befestigt ist.

**11.** Vorrichtung nach Anspruch 10, **dadurch gekennzeichnet, daß** als Justiermittel für die Translation des Gitters (4) und des Gitterhalters (11) vorzugsweise in Richtung der Gitternormalen (401) am Verschiebetisch (14) eine Feingewindeschraube (141) vorhanden ist.

**12.** Vorrichtung nach einem der Ansprüche 1 bis 11, **gekennzeichnet durch** eine zweidimensionale Anordnung zur gezielten Einstellung und Kompensation der chromatischen Dispersion höherer Ordnungen derart, daß das Gitter (4) auf einem Gitterhalter (11) winkelveränderlich montiert ist, und daß dieser auf einem Verschiebetisch (14) sitzt, mit dem das Gitter (4) in Bezug auf den Drehpunkt (9) des Abstimmarms (8) abstandsveränderlich ist.

**13.** Vorrichtung nach einem der Ansprüche 1 bis 12, **dadurch gekennzeichnet, daß** zur gezielten Einstellung und Kompensation der chromatischen Dispersion höherer Ordnungen das Gitter (4) auf einem Gitterhalter (11) so montiert ist, daß der Einfallswinkel θ1 des vom Halbleiterdiodenlaser 81) emittierten Lichts auf das Gitter (4) einstellbar veränderlich ist, und daß der Gitterhalter (11) auf einem Verschiebetisch (14) derart angebracht ist, daß der Abstand x1 zwischen der Gitterebene (401) und dem Drehpunkt (9) des Abstimmarms (8) einstellbar veränderlich ist.

## Claims

**1.** Tuning arrangement for a semiconductor laser (1) provided with an antireflection coating (2) and having an external-cavity resonator of Littman arrangement, comprising at least one optical transmission component (3), an optical diffraction grating (4), furthermore a tuning arm (8) which is rotatable around an axis (9) and to which a cavity end mirror (7) is fastened, as well as adjusting devices (13, 802) for the position of the tuning arm (8) and for the distance ($x_2$) between the mirror plane (701) and the axis of rotation (9) for compensation of the first-order chromatic dispersion of all components contained in the laser by mechanically linking the changes of the geometrical cavity length $L_{geo}$ and of the angular relationship between the grating (4) and the mirror (7), **wherein**, for specific adjustment and compensation of the higher-order chromatic dispersion, the grating (4) is arranged angularly variable and is also variable regarding its distance from the axis of rotation (9) of the tuning arm (8), an adjusting device each (802; 141; 115) being available for the compensation of the chromatic dispersion of each order.

**2.** Arrangement according to claim 1, **wherein** for adjustment of the distance $x_2$ between the axis of rotation (9) and the mirror plane (701), the cavity end mirror (7) is translateable in the direction of the mirror normal (702) by means of an adjusting device (802).

**3.** Arrangement according to claim 2, **wherein** the adjusting device is a large diameter finely threaded screw (802) on which the mirror (7) is fastened so that the mirror (7) is displaceable in the direction of the mirror normal (702) by turning the finely threaded screw (802).

**4.** Arrangement according to claim 1 or claim 2, **wherein** the cavity end mirror (7) is a rectangular prism (15) of such dimensioning that the light beam (5) coming from the grating (4) and entering the prism (15) penetrates the prism (15) through the hypotenuse surface (151), is totally reflected at the first short surface (152) as well as at the second short surface (153) and then leaves the prism (15) again through the hypotenuse surface (151), the line of intersection (154) of the short surfaces (151, 152) of the prism (15) being normal to the grooves (402) of the grating (4).

**5.** Arrangement according to claim 1 or claim 2, **wherein** a cylindrical lens (16) is positioned between the grating (4) and the cavity end mirror (7) so that the direction of the longitudinal axis (161) of the cylindrical lens (16) is substantially normal to the grating grooves (402) and the distance between the mirror plane (701) of the cavity end mirror (7) and the cylindrical lens (16) is equal to the mirror-side focal length of the cylindrical lens (16).

**6.** Arrangement according to any one of claims 1 to 5, **wherein** the grating (4) is fastened on a grating holder (11) having two degrees of freedom of adjustment.

**7.** Arrangement according to claim 6, **wherein** the grating holder (11) is rotatable in two directions by means of adjusting devices (113, 115), the axes of rotation being mutually perpendicular.

8. Arrangement according to claim 7, **wherein** a first direction of rotation for adjustment of the cavity quality/efficiency runs along an axis (114) of the grating holder (11).

9. Arrangement according to any one of claims 6 to 8, **wherein** a second direction of rotation for the choice of the incident angle ($\theta$1) of the light emitted by the semiconductor laser (1) on the grating (4) runs along an axis (116) of the grating holder (11).

10. Arrangement according to any one of claims 6 to 9, **wherein** the distance ($x_1$) between the grating plane (401) and the axis of rotation (9) of the tuning arm (8) is variable by means of a displacement table (14) on which the grating holder (11) is fastened together with the grating (4).

11. Arrangement according to claim 10, **wherein** a finely threaded screw (141) is available at the displacement table (14) as an adjusting device for the translation of the grating (4) and of the grating holder (11) preferably in the direction of the grating normal (401).

12. Arrangement according to any one of claims 1 to 11, **characterized by** a two-dimensional arrangement for specific adjustment and compensation of the higher-order chromatic dispersion in such a way that the grating (4) is mounted on a grating holder (11) to be angularly variable and that said holder is located on a displacement table (14) by means of which the distance between the grating (4) and the pivot (9) of the tuning arm (8) may be varied.

13. Arrangement according to any one of claims 1 to 12, **wherein** for specific adjustment and compensation of the higher-order chromatic dispersion, the grating (4) is mounted on a grating holder (11) in such a way that the incident angle $\theta$1 of the light emitted by the semiconductor diode laser (1) on the grating (4) is variable and wherein the grating holder (11) is mounted on a displacement table (14) in such a way that the distance $x_1$ between the grating plane (401) and the pivot (9) of the tuning arm (8) is variable.

**Revendications**

1. Arrangement accordable pour un laser à diode à semiconducteur (1) pourvu d'un revêtement antiréfléchissant (2) et avec un résonateur externe en agencement Littmann, consistant en au moins un composant de transmission optique (3), en un réseau de diffraction optique (4), en un bras d'accordement (8) qui est rotatif autour d'un axe (9) et sur lequel est fixé un miroir terminal (7) du résonateur, ainsi qu'en des dispositifs de réglage (13, 802) de la position du bras d'accordement (8) et de la distance ($x_2$) entre le plan du miroir (701) et l'axe de rotation (9) pour compenser la dispersion chromatique de premier ordre de tous les composants contenus dans le laser, grâce à une association mécanique des variations de la longueur géométrique du résonateur $L_{geo}$ et du rapport angulaire entre le réseau (4) et le miroir (7), **caractérisé en ce que** pour un réglage voulu et une compensation de la dispersion chromatique d'ordres supérieurs, le réseau (4) est agencé de manière à pouvoir changer d'angle et, par rapport à l'axe de rotation (9) du bras d'accordement (8), à pouvoir changer la distance, un moyen d'ajustage respectif (802; 141; 115) existant pour compenser la dispersion chromatique de chaque ordre.

2. Arrangement selon la revendication 1, **caractérisé en ce que** pour régler la distance $x_2$ entre l'axe de rotation (9) et le plan du miroir (701), la translation du miroir terminal du résonateur (7) en direction de la normale du miroir (702) peut être opérée avec un moyen de réglage (802).

3. Arrangement selon la revendication 2, **caractérisé en ce que** le moyen de réglage est une vis de gros calibre à filetage fin (802), sur laquelle le miroir (7) est fixé de telle manière que le miroir (7) peut être déplacé en direction de la normale du miroir (702) en tournant la vis à filetage fin (802).

4. Arrangement selon la revendication 1 ou 2, **caractérisé en ce que** le miroir terminal du résonateur (7) est un prisme droit (15), dimensionné de manière à ce que le rayon lumineux (6) provenant du réseau (4) et rentrant dans le prisme (15) pénètre dans le prisme (15) par la surface de l'hypoténuse (151), qu'il subit une réflexion totale sur la première surface (152) ainsi que sur la seconde surface (153) du côté de l'angle droit, et qu'il sort ensuite du prisme (15) par la surface de l'hypténuse (151), la ligne droite de recoupement (154) des surfaces du côté de l'angle droit (151, 152) du prisme étant perpendicaulaire aux sillons (402) du réseau (4).

**5.** Arrangement selon la revendication 1 ou 2, **caractérisé en ce qu'**une lentille cylindrique (16) est positionnée entre le réseau (4) et le miroir terminal du résonateur (7), de manière à ce que la direction de l'axe longitudinal (161) de la lentille cylindrique (16) est orientée à peu près perpendiculairement aux sillons du réseau (402) et que la distance entre le plan (701) du miroir terminal du résonateur (7) et la lentille cylindrique (16) est égale à la focale de la lentille cylindrique (16), en direction du miroir.

**6.** Arrangement selon l'une des revendications 1 à 5, **caractérisé en ce que** le réseau (4) est fixé sur un support de réseau (11) à deux degrés de liberté de réglage.

**7.** Arrangement selon la revendication 6, **caractérisé en ce que** le support (11) du réseau peut être tourné en deux directions à l'aide de moyens d'ajustage (113, 115), les axes de rotation étant perpendiculaires l'un à l'autre.

**8.** Arrangement selon la revendication 7, **caractérisé en ce que** pour ajuster la qualité du résonateur, une première direction de rotation va le long d'un axe (114) du support (11) du réseau.

**9.** Arrangement selon l'une des revendications 6 à 8, **caractérisé en ce que** pour choisir l'angle d'incidence ($\Theta$1) de la lumière émise par le laser à diode à semiconducteur (1) sur le réseau (4), une seconde direction de rotation va le long d'un axe (116) du support (11) du réseau.

**10.** Arrangement selon l'une des revendications 6 à 9, **caractérisé en ce que** la distance (x1) entre le plan du réseau (401) et l'axe de rotation (9) du bras d'accordement (8) peut être changée au moyen d'une table coulissante (14), sur laquelle est fixé le support de réseau (11), ensemble avec le réseau (4).

**11.** Arrangement selon la revendication 10, **caractérisé en ce que** comme moyen d'ajustage pour la translation du réseau (4) et du support (11) du réseau, de préférence en direction de la normale du réseau (401), il y a une vis à filetage fin (141) sur la table coulissante (14).

**12.** Arrangement selon l'une des revendications 1 à 11, **caractérisé par** un agencement bidimensionnel pour un réglage voulu et une compensation de la dispersion chromatique d'ordres supérieurs, de manière à ce que le réseau (4) est installé à angle variable sur un support de réseau (11) et que ce dernier se trouve sur une table coulissante (14), avec laquelle la distance du réseau (4) peut être changée par rapport au centre de rotation (9) du bras d'accordement (8).

**13.** Arrangement selon l'une des revendications 1 à 12, **caractérisé en ce que** pour un réglage voulu et une compensation de la dispersion chromatique d'ordres supérieurs, le réseau (4) est installé de telle manière sur un support de réseau (11) que l'angle d'incidence $\Theta$1 de la lumière émise par le laser à diode à semiconducteur (1) sur le réseau (4) peut être changé par réglage, et que le support (11) du réseau est installé de telle manière sur une table coulissante (14) que la distance x1 entre le plan du réseau (401) et le centre de rotation (9) du bras d'accordement (8) peut être changée par réglage.

Fig. 1A

8

7

9

1

2

3

6

4

5

Fig. 1B

61

152

154

62    151    15    153

Fig. 1C

61

162    701

optische
Achse

62    161    16    7

Fig. 2

10  8  101  7  701  802  801  12  103

6, 702

13

9  1  2  3  14  11  4  401  5

113  141  115

EP 0 801 451 B1

# Fig. 3A

# Fig. 3B

Fig. 5

8 101 1 2 802 7 701 6, 702

9 403

$x_1$ $x_2$

$x_0$

$\theta_2$ $\theta_1$

$L_2$

$L_1$

4 401 404

EP 0 801 451 B1

Fig. 4A    Fig. 4B    Fig. 4C

Fig. 6

EP 0 801 451 B1